# EUROPEAN PATENT APPLICATION

(11) **EP 1 998 146 A2**
(43) Date of publication of application: **03.12.2008**
(21) Application number: 08009945.0
(22) Date of filing: 30.05.2008
(51) Int. Cl.: G01D 5/14

(54) **Position detector and positioning device**

(30) Priority: 31.05.2007 JP 2007144657
(71) Applicant: Konica Minolta Opto, Inc., Hachioji-shi, Tokyo 192-8505 (JP)
(72) Inventor: Yoshida, Ryuichi, Tokyo 192-8505 (JP); Hoshino, Takayuki, Hachioji-shi Tokyo 192-8505 (JP); Sugitani, Kazumi, Hachioji-shi Tokyo 192-8505 (JP)
(74) Representative: HOFFMANN EITLE

(57) **Abstract**

There is provided a position detector by which output having linearity can be obtained in a wide range, which has a movable member 2 that is magnetized into N-poles 3 and S-poles 4 arranged in a movable direction and two magnetic detection elements 5 that are arranged in the movable direction in face of the movable member 2 and that detect variation of magnetic field, in which there are performed an operation (A-B)/(A+B)+2 when A≥0 and A+B≥0 (wherein A and B are detection signals of the two magnetic detection elements 5), an operation (A+B)/(B-A) when A<0 and B≥0, and an operation (A-B)/(A+B)-2 when B<0, and A+B<0.

## Description

This application is based on application No. 2007-144657 filed in Japan, the contents of which are hereby incorporated by reference.

### BACKGROUND OF THE INVENTION

The present invention relates to a position detector and a positioning device.

There has been known a method of calculating, at high resolution, a position of a movable member on which N-poles and S-poles are alternately magnetized, through phase calculation based on an operation of an arctnan(A/B), wherein A and B are intensities of magnetic fields detected by two magnetic detection elements. The operation of the arctnan(A/B), however, involves a heavy processing load, which may cause a problem in that the operation cannot catch up with high-velocity movement of the movable member.

Therefore, a method is conceivable in which the arctnan(A/B) is determined on basis of values A and B with reference to a table in which operation results of the arctnan(A/B) have previously been stored. Assuming that resolutions for A and B are 10 bits, it is necessary to store as many as 1048576 (1024 by 1024) items of data in the table, and this would require a large memory space and would cause cost increase.

In EP 1884747 there is disclosed a position detector in which operation load is reduced and necessity of storing a reference table is omitted with use of different operation expressions corresponding to cases of A>0, B<0, and A≤0 and B≥0.

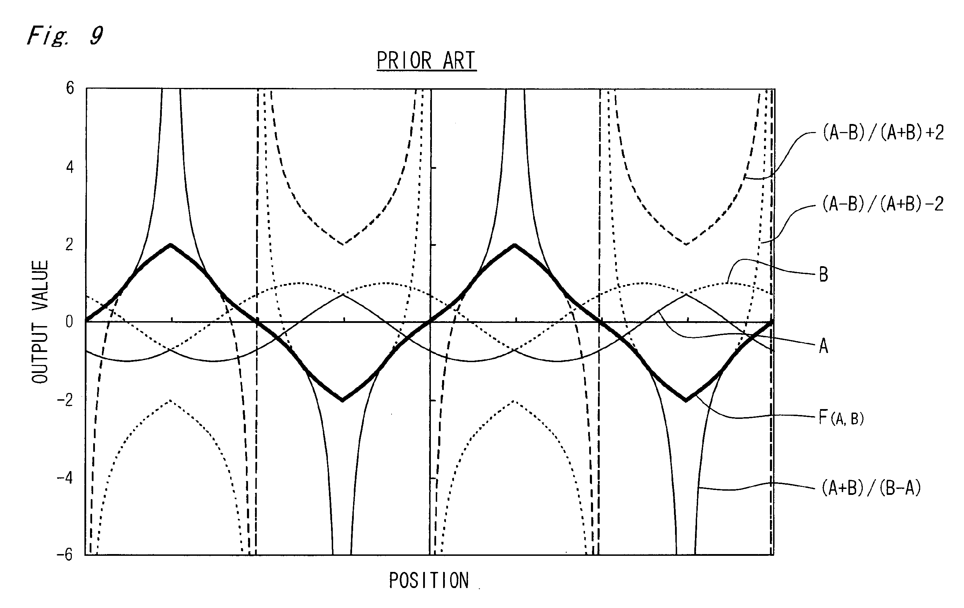

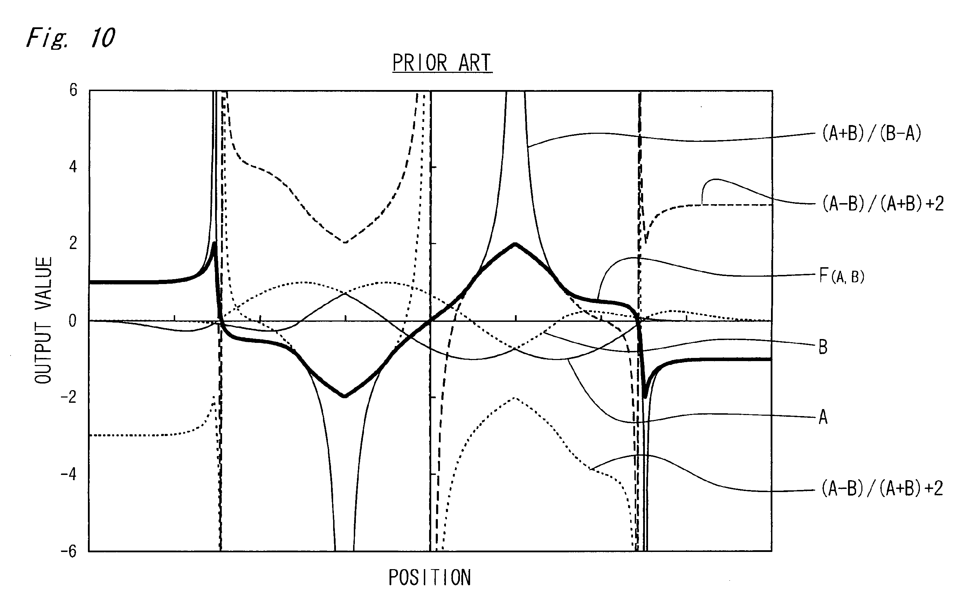

In a position detector disclosed in EP 1884747, as shown in Fig. 9, there are obtained operation values that repeat generally linear increase and decrease for every interval of magnetization between N-poles and S-poles. In the position detector of EP 1884747 in which detector only one set of N-pole and S-pole is magnetized, generally linear operation values are obtained in an interval of magnetization between the N-pole and the S-pole, as shown in Fig. 10.

When the position detector of EP 1884747 goes beyond a range of the interval of magnetization between N-poles and S-poles, it is impossible to determine a position of the movable member only with use of the operation values.

### SUMMARY OF THE INVENTION

In consideration of above problems, it is an object of the invention is to provide a position detector by which linear output is obtained in a wide range exceeding an interval of magnetization between N-pole and S-pole.

In order to achieve the object, a position detector according to the invention has a movable member that is movable in a specified movable direction and that is magnetized into at least one N-pole and at least one S-pole arranged in the movable direction and two magnetic detection elements that are arranged in the movable direction facing the movable member and that each detects variation of magnetic field, calculates an operation value indicating a position of the movable member on the basis of detection signals A and B of the two magnetic detection elements, and performs switching among operation expressions, in accordance with positiveness/negativeness of A, B and A+B.

In this configuration, where operation expressions are switched in accordance with positiveness/negativeness of A+B, operation values on condition that A+B is positive and operation values on condition that A+B is negative can be joined together so as to vary linearly and thus a range in which linear output is obtained can be widened.

In the position detector of the invention may perform an operation (A-B)/(A+B)+2 when A≥0 and A+B≥0, an operation (A+B)/(B-A) when A<0 and B≥0, and an operation (A-B)/(A+B)-2 when B<0, and A+B<0.

In this configuration, linear operation values can be obtained in a range almost twice as wide as the interval of magnetization between N-pole and S-pole.

In the position detector of the invention may perform an operation (A+B)/(B-A)+4 when A≥0, B<0, and A+B≥0, the operation (A-B)/(A+B)+2 when A≥0, B≥0, and A+B≥0, the operation (A+B)/(B-A) when A<0 and B≥0, the operation (A-B)/(A+B)-2 when A<0, B<0, and A+B<0, and an operation (A+B)/(B-A)-4 when A≥0, B<0, and A+B<0.

In this configuration, linear operation values can be obtained in a range generally twice as wide as the interval of magnetization between N-pole and S-pole and the operation values can be prevented from diverging.

In the position detector of the invention, a spacing between the two magnetic detection elements may be odd number times as large as half of the interval of magnetization between the N-poles and the S-poles.

In this configuration, slopes of the linear portions of the operation value of the operation expressions are equal, so that joining the linear portions of the operation expressions results in linear operation output.

In the invention, the operation expressions are switched in accordance with positiveness/negativeness of A, B and A+B, and thus linear operation values can be obtained in a range generally twice as wide as the interval of magnetization between N-pole and S-pole, so that the position of the movable member can uniquely be determined.

### BRIEF DESCRIPTION OF THE DRAWINGS

These and other objects and features of the present invention will become apparent from the following description taken in conjunction with the preferred embodiments thereof with reference to the accompanying drawings, in which:

Fig. 1 is a diagram showing a configuration of a positioning device according to a first embodiment of the invention;

Fig. 2 is a graph showing detection signals and operation outputs of a position detector of Fig. 1;

Fig. 3 is a graph showing outputs based on alternative operations in the positioning device of Fig. 1;

Fig. 4 is a diagram showing a configuration of a positioning device according to a second embodiment of the invention;

Fig. 5 is a graph showing detection signals and operation outputs of a position detector of Fig. 4;

Fig. 6 is a graph showing outputs based on inadequate operations in the positioning device of Fig. 4;

Fig. 7 is a graph showing outputs based on alternative operations in the positioning device of Fig. 4;

Fig. 8 is a graph showing outputs based on inadequate operations in the positioning device of Fig. 4;

Fig. 9 is a graph showing detection signals and operation outputs of a conventional position detector; and

Fig. 10 is a graph showing detection signals and operation outputs of a conventional position detector.

### DETAILED DESCRIPTION OF THE INVENTION

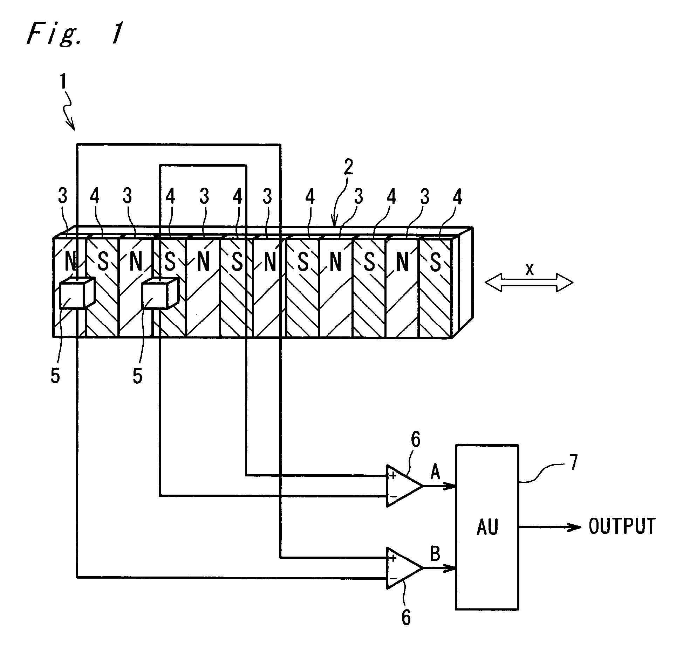

Fig. 1 shows a configuration of a position detector 1 according to a first embodiment of the invention. The position detector 1 is configured so that N-poles 3 and S-poles 4 are alternately magnetized at a given interval of magnetization on a surface of a movable member 2 movable in x-direction, so that intensities of magnetic fields formed by the movable member 2 are detected by two Hall elements (magnetic field detection elements) 5 fixed facing the movable member 2, so that detection signals from the Hall elements 5 are inputted through amplifiers 6 into an arithmetic unit 7, and so that a position of the movable member 2 is thereby calculated.

The movable member 2 is fixed to a detection object such as a mobile of an actuator so as to move together with the detection object. The two Hall elements 5 are fixed with a spacing that is 5/2 times as large as the interval of magnetization (corresponding to 1 + 1/4 periods).

The arithmetic unit 7 performs switching among operation expressions for use, in accordance with positiveness/negativeness of A, B and A+B, where A and B are outputs of the Hall elements 5, respectively. Specifically, the arithmetic unit 7 performs:
an operation (A-B)/(A+B)+2 when A≥0 and A+B≥0;
an operation (A+B)/(B-A) when A<0 and B≥0; and
an operation (A-B)/(A+B)-2 when B<0, and A+B<0.

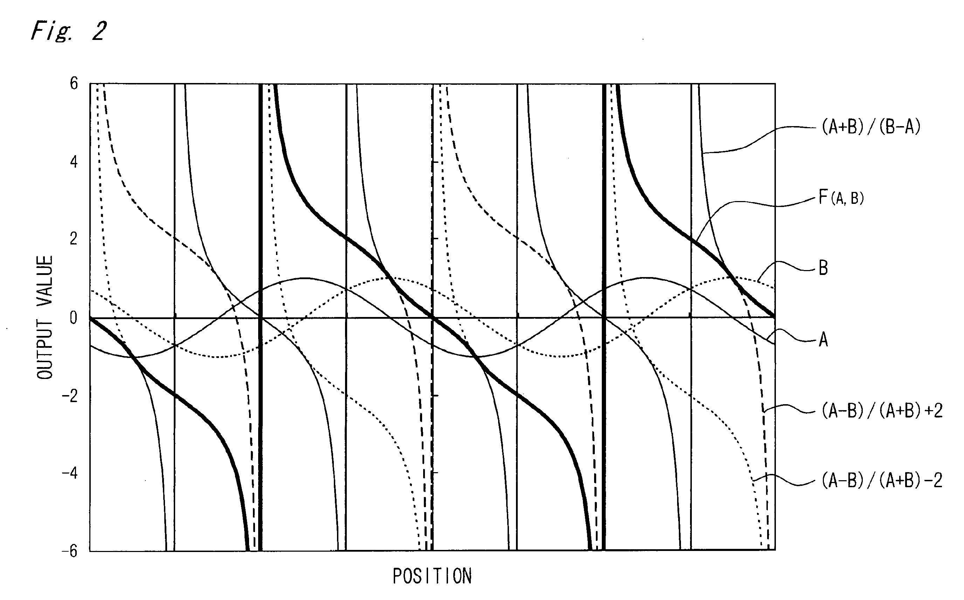

In Fig. 2 there are shown variation in output value F(A,B) from the arithmetic unit 7 that corresponds to positions of the movable member 2, as well as outputs A, B of the Hall elements 5, operation values of three operation expressions (A+B)/(B-A), (A-B)/(A+B)+2, and (A-B)/(A+B)-2.

The outputs A and B periodically fluctuate corresponding to position of the movable member 2 so as to be maximized when the corresponding Hall element 5 confronts the N-poles 3, and so as to be minimized when the corresponding Hall element 5 confronts the S-poles 4. That is, a horizontal distance between a maximum value and a minimum value of the output A or B (a half of a period of A, B) corresponds to an interval of magnetization between the N-poles 3 and the S-poles 4.

Each of values of (A+B) and (B-A) becomes zero at every interval of magnetization (every half of the period). The value of the operation (A+B)/(B-A) diverges (becomes ±∞) on occasion of (B-A)=O, and the values (A-B)/(A+B)+2 and (A-B)/(A+B)-2 diverge on occasion of (A+B)=0. The values of each operation expression have portions that undergo generally linear variation at centers between the positions of the divergence.

On occasion of the detection signal A=0, (A+B)/(B-A)=B/B=1 holds and (A-B)/(A+B)+2=-B/B+2=1 holds. On occasion of the detection signal B=0, (A+B)/(B-A)=-A/A=-1 holds and (A-B)/(A+B)-2=A/A-2=-1 holds.

By switch of the operation expression to (A+B)/(B-A) on occasion of A=0 before (A-B)/(A+B)+2 diverges and switch of the expression to (A-B)/(A+B)-2 on occasion of B=0 before (A+B)/(B-A) diverges, in consideration of above, the generally linear portions of the operation expressions can be joined together and non-divergent continuous output F(A,B) can be obtained in a range 3/2 or more times as wide as the interval of magnetization.

With the spacing between the two Hall elements 5 being odd number times as large as the half of the interval of magnetization between the N-poles 3 and the S-poles 4 such that A and B are 90° out of phase with each other, particularly, slopes of the linear ranges of the operation expressions are made equal, and thus the generally linear output F(A,B) can be obtained in a range 3/2 or more times as wide as the interval of magnetization.

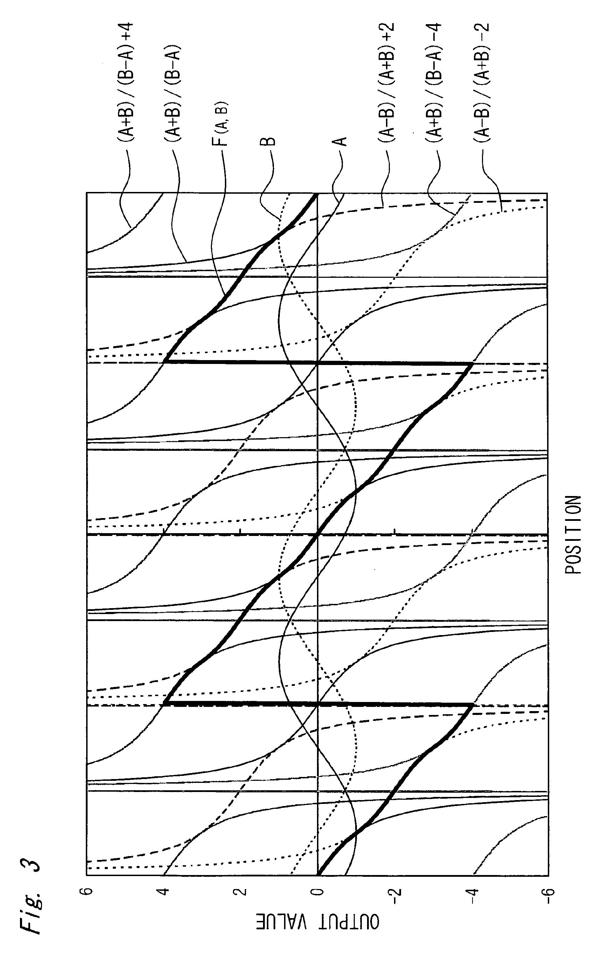

Fig. 3 shows an alternative in which additional operation expressions are used in the position detector 1 according to the embodiment. In the alternative, the arithmetic unit 7 performs:
an operation (A+B)/(B-A)+4 when A≥0, B<0, and A+B≥0;
the operation (A-B)/(A+B)+2 when A≥0, B≥0, and A+B≥0;
the operation (A+B)/(B-A) when A<0 and B≥0;
the operation (A-B)/(A+B)-2 when A<0, B<0, and A+B<0; and
an operation (A+B)/(B-A)-4 when A≥0, B<0, and A+B<0.

The operation expressions (A+B)/(B-A)+4 and (A+B)/(B-A)-4 diverge on occasion of (B-A)=0 but undergo generally linear variation at centers between those positions.

On occasion of the detection signals A>0 and B=0, (A-B)/(A+B)+2=A/A+2=3 holds and (A+B)/(B-A)+4=A/(-A)+4=3 holds. On occasion of the detection signals A=0 and B<0, (A-B)/(A+B)-2=-B/B-2=-3 holds and (A+B)/(B-A)-4=B/B-4=-3 holds.

By switch between the operation expressions (A-B)/(A+B)+2 and (A+B)/(B-A)+4 on occasion of A>0 and B=0 and switch between the operation expressions (A-B)/(A+B)-2 and (A+B)/(B-A)-4 on occasion of A=0 and B<0, therefore, the linear portions of the five operation expressions can be joined together and operation output F(A,B) can be prevented from diverging with respect to all possible detection signals A and B.

With A and B being 90° (half of the interval of magnetization) out of phase with each other, particularly, slopes of the linear ranges of the operation expressions become equal, and thus generally linear and sawtoothed output F(A,B) can be obtained in a range two times as wide as the interval of magnetization, as shown in the drawing.

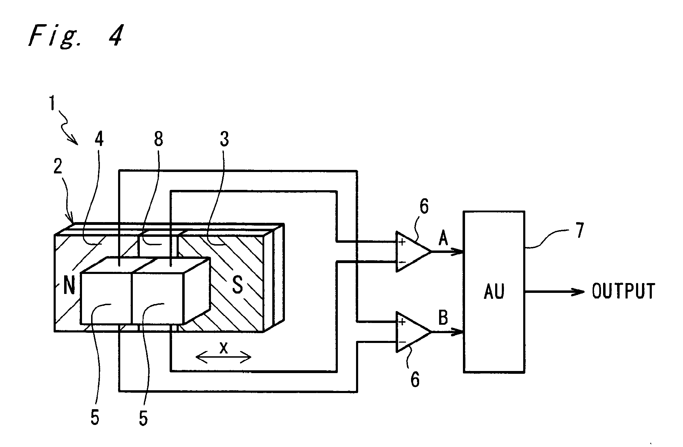

Fig. 4 shows a position detector 1 according to a second embodiment of the invention. For the present embodiment, the same components thereof as those of the first embodiment are designated by the same reference characters, and description thereof is omitted. In the embodiment, an N-pole 3 and an S-pole 4 are magnetized in respective positions on the movable member 2 and a non-magnetized part 8 is provided between the N-pole 3 and the S-pole 4.

In the embodiment, as is the case with the first embodiment, the arithmetic unit 7 performs:
the operation (A-B)/(A+B)+2 when A≥0 and A+B≥0;
the operation (A+B)/(B-A) when A<0 and B≥0; and
the operation (A-B)/(A+B)-2 when B<0, and A+B<0.

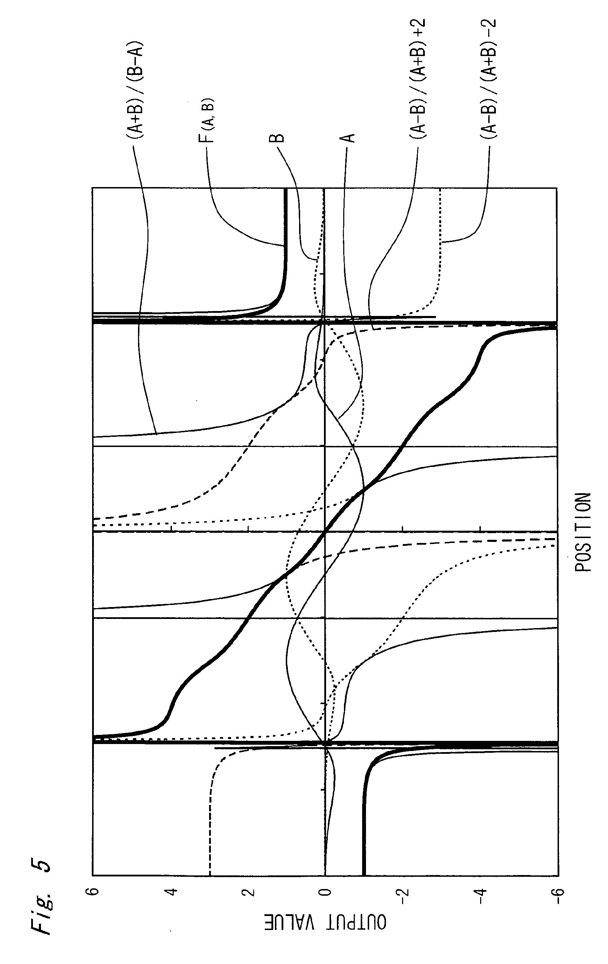

In Fig. 5 there are shown outputs A, B of the Hall elements 5 that correspond to positions of the movable member 2, operation values of the three operation expressions (A+B)/(B-A), (A-B)/(A+B)+2, and (A-B)/(A+B)-2, and output value F(A,B) from the arithmetic unit 7. At a horizontally center position in Fig. 5, a midpoint between the two Hall elements 5 just confronts a midpoint between the N-pole 3 and the S-pole 4. At the center position, the smaller of the outputs of the Hall elements 5 is set as A, and the larger is set as B.

In the embodiment also, as shown in the drawing, linear portions of the three operation expressions can be joined together, and thus generally linear output F(A,B) can be obtained in a range 3/2 or more times as wide as the interval of magnetization.

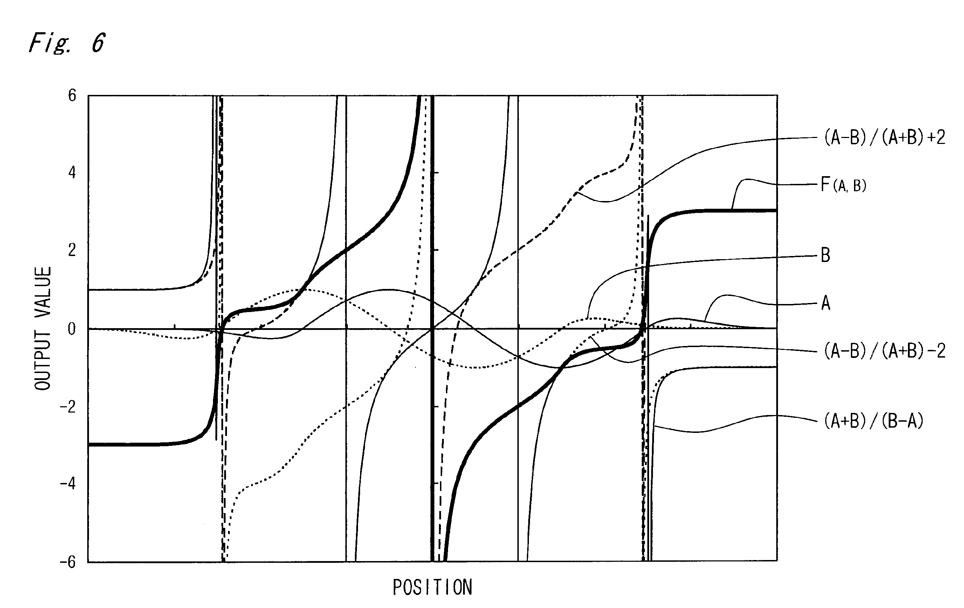

Providing that the larger of the outputs of the Hall elements 5 is set as A and the smaller is set as B in the position where the midpoint between the two Hall elements 5 just confronts the midpoint between the N-pole 3 and the S-pole 4, the operation output F(A,B) diverges at the horizontal center, as shown in Fig. 6, and thus fails to provide linear output. Where one N-pole 3 and one S-pole 4 exist, therefore, the smaller of the outputs of the Hall elements 5 has to be A and the larger has to be B in the position of confrontation with the midpoint between the N-pole 3 and the S-pole 4.

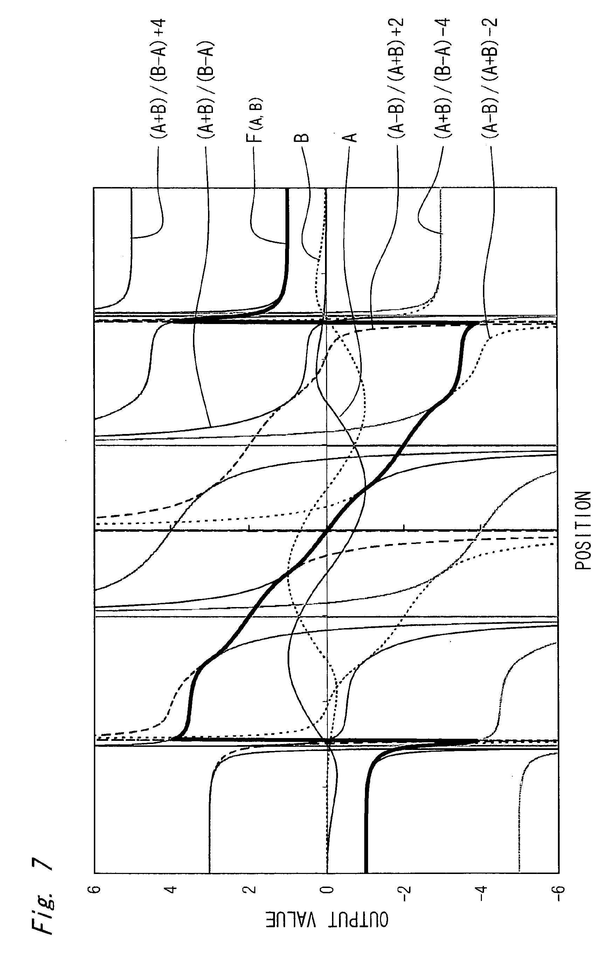

Fig. 7 shows an alternative in which additional operation expressions are used in the position detector 1 according to the second embodiment. In the alternative, the arithmetic unit 7 performs:
the operation (A+B)/(B-A)+4 when A≥0, B<0, and A+B≥0;
the operation (A-B)/(A+B)+2 when A≥0, B≥0, and A+B≥0;
the operation (A+B)/(B-A) when A<0 and B≥0;
the operation (A-B)/(A+B)-2 when A<0, B<0, and A+B<0; and
the operation (A+B)/(B-A)-4 when A≥0, B<0, and A+B<0.

Where one N-pole 3 and one S-pole 4 exist in the alternative, the linear range cannot be widen but the divergence of the operation output F(A,B) can be eliminated in comparison with the embodiment having the three operation expressions.

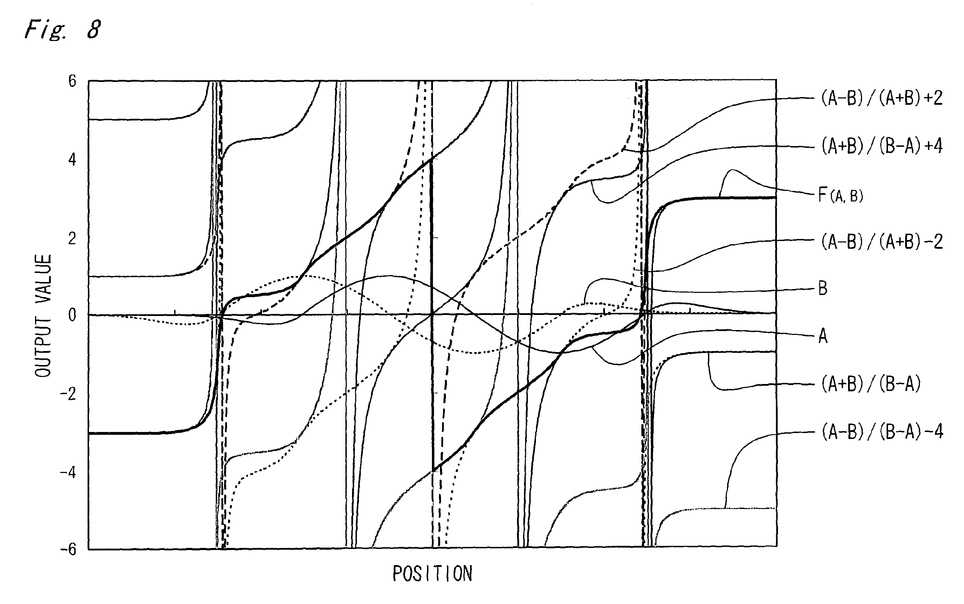

Providing that the larger of the outputs of the Hall elements 5 is set as A and the smaller is set as B in the position where the midpoint between the two Hall elements 5 just confronts the midpoint between the N-pole 3 and the S-pole 4, in the alternative, the operation output F(A,B) diverges at the horizontal center, as shown in Fig. 8. Thus magnitude relation between the outputs A and B should be ensured.

In the invention, the movement of the magnetized movable member means relative movement thereof with respect to the magnetic detection elements. In the position detector of the invention that is applied to a self-propelled actuator, an absolute position of the magnetized movable member does not vary while absolute positions of the magnetic detection elements are shifted. Such a case, however, is not excluded from the invention because it is understood that the position of the movable member relative to the magnetic detection elements is calculated therein.

Although the present invention has been fully described in connection with the preferred embodiment thereof with reference to the accompanying drawings, it is to be noted that various changes and modifications are apparent to those skilled in the art. Such changes and modifications are to be understood as included within the scope of the present invention.

## Claims

1. A position detector comprising:
a movable member that is movable in a specified movable direction and that is magnetized into at least one N-pole and at least one S-pole arranged in the movable direction and,
two magnetic detection elements that are arranged in the movable direction facing the movable member and that each detects variation of magnetic field,
the position detector calculating an operation value indicating a position of the movable member on the basis of detection signals A and B of the two magnetic detection elements,
the position detector performing switching among operation expressions, in accordance with positiveness/negativeness of A, B and A+B.

2. The position detector as claimed in Claim 1, wherein there are performed:
an operation (A-B)/(A+B)+2 when A≥0 and A+B≥0;
an operation (A+B)/(B-A) when A<0 and B≥0; and
an operation (A-B)/(A+B)-2 when B<0, and A+B<0.

3. The position detector as claimed in Claim 1, wherein there are performed:
an operation (A+B)/(B-A)+4 when A≥0, B<0, and A+B≥0;
an operation (A-B)/(A+B)+2 when A≥0, B≥0, and A+B≥0;
an operation (A+B)/(B-A) when A<0 and B≥0;
an operation (A-B)/(A+B)-2 when A<0, B<0, and A+B<0; and
an operation (A+B)/(B-A)-4 when A≥0, B<0, and A+B<0.

4. The position detector as claimed in Claim 2,
wherein the N-pole and the S-pole are each magnetized in one position, and
wherein the smaller of the detection signals of the magnetic detection elements is set as A and the larger of the detection signals is set as B in a position where a midpoint between the two magnetic detection elements just confronts a midpoint between the N-pole and the S-pole.

5. The position detector as claimed in Claim 3,
wherein the N-pole and the S-pole are each magnetized in one position, and
wherein the smaller of the detection signals of the magnetic detection elements is set as A and the larger of the detection signals is set as B in a position where a midpoint between the two magnetic detection elements just confronts a midpoint between the N-pole and the S-pole.

6. The position detector as claimed in any one of preceding Claims 1-5, wherein a spacing between the two magnetic detection elements is odd number times as large as half of an interval of magnetization between the N-poles and the S-poles.
